# EUROPÄISCHE PATENTSCHRIFT

(11) **EP 3 574 725 B1**
(45) Veröffentlichungstag und Bekanntmachung des Hinweises auf die Patenterteilung: **21.04.2021**
(21) Anmeldenummer: 18700569.9
(22) Anmeldetag: 15.01.2018
(51) Int. Cl.: H05K 5/06, H05K 9/00

(54) **EMV ABSCHIRMENDE DICHTUNG UND ELEKTRISCHES ODER ELEKTRONISCHES GERÄT MIT EINER DICHTUNG**
EMC-SHIELDING SEAL AND ELECTRICAL OR ELECTRONIC DEVICE COMPRISING A SEAL
JOINT DE BLINDAGE À CEM ET APPAREIL ÉLECTRIQUE OU ÉLECTRONIQUE COMPORTANT UN JOINT

(30) Priorität: 25.01.2017 DE 102017101414
(43) Veröffentlichungstag der Anmeldung: 04.12.2019
(73) Patentinhaber: SMA Solar Technology AG, 34266 Niestetal (DE)
(72) Erfinder: LAMPE, Frank, 34302 Guxhagen (DE); BETHKE, Lars, 37083 Göttingen (DE); DITTMAR, Jens, 34326 Morschen-Neumorschen (DE)
(86) Internationale Anmeldenummer: PCT/EP2018/050850
(87) Internationale Veröffentlichungsnummer: WO 2018/137953

(56) Entgegenhaltungen:
- WO-A1-97/46064
- WO-A1-97/47166
- DE-U1-202014 101 818

## Beschreibung

### TECHNISCHES GEBIET DER ERFINDUNG

Die Erfindung bezieht sich auf eine Dichtung zur IP-dichtenden und EMV-abschirmenden Verbindung von Gehäusebauteilen eines elektrischen oder elektronischen Gerätes.

Indem ein elektrisches oder elektronisches Gerät aus verschiedenen Gehäusebauteilen aufgebaut wird, lassen sich unterschiedliche Anforderungen an die einzelnen Gehäusebauteile individuell umsetzen. Ein derartiges Gerät bietet oftmals einen Kosten/Nutzen Vorteil gegenüber einem Gerät, welches lediglich ein Gehäusebauteil beinhaltet, weil dort entweder das eine Gehäusebauteil stets auf einen Kompromiss unterschiedlicher Anforderungen hin auszulegen ist, was technisch nachteilig ist, oder aber eine Herstellung des Gehäusebauteils durch einen Ansatz, allen unterschiedlichen Anforderungen gerecht zu werden, zu teuer wird. Durch eine Realisierung des Gerätes mit mehreren Gehäusebauteilen lassen sich diese Nachteile, insbesondere bei komplexen Geräten wie z.B. Wechselrichtern, die für einen Betrieb im Freien ausgelegt sind, beseitigen. Im Gegenzug werden dabei jedoch sowohl hinsichtlich des IP-Schutzes, als auch hinsichtlich einer Reduktion von Störstrahlung zwischen miteinander verbundenen Gehäusebauteilen hohe Anforderungen gestellt. So soll einerseits die IP-Dichtwirkung, wie auch die EMV-Abschirmung selbst bei Schwankungen der Grenzflächenabstände zueinander möglichst wenig beeinflusst werden. Gleichzeitig soll eine entsprechende Dichtung leicht herstellbar und auf einfache Art und Weise im Gerät verbaut werden können.

### STAND DER TECHNIK

Eine Dichtung der eingangs erwähnten Art wird bei einem mehrere Gehäusebauteile aufweisenden elektrischen oder elektronischen Gerät beispielsweise zwischen zwei den jeweiligen Gehäusebauteilen zugeordneten Grenzflächen eingesetzt. In ihrem Einbauzustand stellt sie einerseits einen IP-Schutz bereit, und schützt das Innere des Gerätes vor einem Eindringen von Fremdkörpern und/oder Wasser. Als Fremdkörper sind beispielsweise Staubpartikel zu nennen. Gleichfalls umfasst der Schutz vor dem Eindringen von Fremdkörpern aber auch einen Berührschutz, der verhindert, dass unter Spannung stehende Bauteile im Inneren des Gerätes bei dessen Betrieb berührt werden. Gleichzeitig stellt sie jedoch über eine niederimpedante elektrische Verbindung der Gehäusebauteile miteinander auch eine EMV-abschirmende Wirkung an den Grenzflächen der betroffenen Gehäusebauteile bereit. So reduziert sie einerseits ein Austreten von elektromagnetischer Störstrahlung aus dem Inneren des Gerätes in die Umgebung. Andererseits verhindert sie, dass sich zwischen den Gehäusebauteilen eine zeitlich fluktuierende Potentialdifferenz ausbildet, wodurch die Gehäusebauteile als Antenne wirken und in unerwünschter Weise elektromagnetische Störstrahlung in die Umgebung abstrahlen würden.

Über den dem IP (**I**nternational **P**rotection oder auch **I**ngress **P**rotection) - Schutz zugeordneten IP-Code wird üblicherweise die IP-Schutzklasse - und darüber auch ein erlaubter Einsatzbereich - eines elektrischen Gerätes charakterisiert. Dabei besteht der IP-Code aus zwei Kennziffern, von denen die erste den Schutz gegen das Eindringen eines Fremdkörpers, und die zweite den Schutz gegen das Eindringen von Wasser klassifiziert. Bei beiden Kennziffern nimmt die Schutzwirkung jeweils mit zunehmendem Wert der Kennziffer zu.

Zur Bereitstellung des IP-Schutzes zwischen Gehäusebauteilen sind Elastomer - Dichtungen bekannt, die zwischen Grenzflächen benachbarter Gehäusebauteile verbaut werden und in ihrem Einbauzustand verpresst werden. Über ihre elastischen Eigenschaften gleichen sie Gehäuseunebenheiten bis zu einem gewissen Grad aus und verhindern über Ihre Verpressung das Eindringen von Schmutz und/oder Wasser in das Innere des Gerätes. Derartige Dichtungen stellen jedoch lediglich eine IP-dichtende Wirkung, nicht aber eine EMV-abschirmende Wirkung an den Grenzflächen bereit.

Hinsichtlich einer EMV-Abschirmung ist andererseits ein Einsatz metallischer Kontaktfedern bekannt. Die Kontaktfedern lassen sich an eine Grenzfläche eines Gehäusebauteiles montieren. Im Einbauzustand stellen sie dadurch bei Verbindung mit dem anderen Gehäusebauteil einen bzw. mehrere elektrische Kontakte zwischen beiden Gehäusebauteilen bereit und reduzieren so ein Austreten von elektromagnetischer Störstrahlung aus dem Gerät in die Umgebung. Derartige Kontaktfedern werden oftmals in einer Vielzahl entlang einer betroffenen Grenzfläche eines Gehäusebauteils montiert. Eine derartige EMV-Abschirmung stellt jedoch keine IP-dichtende Wirkung der verbundenen Gehäusebauteile bereit.

Daneben sind auch sogenannte Kombi-Dichtungen (vgl. z.B. Flyer *Product Overview* der Fa. Micro Tech Components GmbH, http://www.mtc.de/sites/default/files/linkables/flyer_ihv.pdf) bekannt, die sowohl einen IP-Schutz als auch eine EMV-abschirmende Wirkung in Kombination bereitstellen. Eine derartige Kombi-Dichtung weist ein Kernmaterial aus einem Elastomer auf, wobei das Kernmaterial teilweise von einem Metallgeflecht oder einer Metallfolie ummantelt ist. Über die elastischen Eigenschaften des Kernmaterials wird der IP-Schutz bereitgestellt, während das außenliegende Metallgeflecht im Kontakt mit den metallischen Gehäusebauteilen bzw. deren Grenzflächen eine elektrische Verbindung der Grenzflächen miteinander und somit die EMV-abschirmende Wirkung bereitstellt. Allerdings wird über die außen um den Kern aufgebrachte Ummantelung mit dem Metallgeflechtes oder mit der Metallfolie eine IP-dichtende Wirkung des Kernmaterials reduziert, weswegen eine derartige Dichtung nicht ausgelegt ist, einen hochwertigen IP-Schutz, insbesondere einen IP-Schutz der Klassen IP-4X, IP-5X oder IP-6X bereitzustellen. Dies liegt bei dem Metallgeflecht daran, dass über das Metallgeflecht zusätzliche Unebenheiten auf die Dichtungsoberfläche - zumindest an einem Teil der Dichtungsoberfläche - aufgebracht werden. Wird ein Teil der Dichtungsoberfläche mit einer Metallfolie ummantelt, so ist dieser Teil aufgrund der geringer elastischen Metallfolie nicht - zumindest jedoch weniger stark - in der Lage, Unebenheiten an den Grenzflächen auszugleichen, wodurch die IP-dichtende Wirkung der Kombi-Dichtung beeinträchtigt wird. Aus einem ähnlichen Grund ist die derartige Kombi-Dichtung auch nur beschränkt in der Lage, Schwankungen im Abstand der Grenzflächen zueinander und/oder Unebenheiten der Grenzflächen auszugleichen.

Aus der Schrift WO 97/47166 A1 ist ein Gehäuse zur Aufnahme elektrischer und elektronischer Baugruppen mit einer Frontplatte bekannt. Um eine besonders kostengünstige Befestigung der Frontplatte und gleichzeitig eine EMV-Abschirmung und IP-Dichtigkeit zu erreichen, wird die Frontplatte an einem Haltesteg des Gehäuses angeordnet. Der Haltesteg umgibt eine frontseitige Öffnung in einer zurückgesetzten Anordnung und ragt in die frontseitige Öffnung hinein. Eine Anordnung leitfähiger Federelemente und einer elastischen Dichtung hält die Frontplatte schraublos, sowie EMV-abgeschirmt und IP-dicht.

### AUFGABE DER ERFINDUNG

Die Erfindung ist wie in Anspruch 1 dargelegt.

Der Erfindung liegt die Aufgabe zugrunde, in verbesserter Form sowohl eine IP-dichtende Verbindung, wie auch eine EMV-abschirmende Wirkung zwischen zwei Gehäusebauteilen eines elektrischen oder elektronischen Gerätes bereitzustellen. Insbesondere soll sowohl die IP-dichtende Verbindung als auch die EMV-abschirmende Wirkung selbst bei Abstandsschwankungen zwischen den Gehäusebauteilen bzw. deren Grenzflächen zueinander und/oder Unebenheiten der Grenzflächen in hohem Maß gewährleistet sein. Dabei soll die Dichtung möglichst kostengünstig herstellbar sein, wie auch einfach in dem elektrisches oder elektronisches Gerät verbaut werden können. Der Erfindung liegt weiterhin die Aufgabe zugrunde, ein elektrisches oder elektronisches Gerät mit einer derartigen Dichtung aufzuzeigen.

### LÖSUNG

Die Aufgabe der Erfindung wird durch eine Dichtung mit den Merkmalen des unabhängigen Patentanspruchs 1 gelöst. Die abhängigen Patentansprüche 2 bis 13 sind auf bevorzugte Ausführungsformen der Dichtung gerichtet. Der nebengeordnete Patentanspruch 14 betrifft ein elektrisches oder elektronisches Gerät mit einer derartigen Dichtung.

### BESCHREIBUNG DER ERFINDUNG

Eine erfindungsgemäße Dichtung zur IP-dichtenden und EMV-abschirmenden Verbindung zwischen einem ersten und einem zweiten Gehäusebauteil eines elektrischen oder elektronischen Gerätes umfasst:
- einen ein Elastomer aufweisenden Dichtkörper und
- einen in den Dichtkörper teilweise eingebetteten metallischen Träger.

Die Dichtung ist dadurch gekennzeichnet, dass der Dichtkörper und der Träger adhäsiv und/oder formschlüssige miteinander verbunden sind, so dass hierdurch ein Werkstoffverbund gebildet wird. Dabei weist der Träger eine Mehrzahl aus dem Dichtkörper herausragender metallischer Kontaktsegmente auf. In einem Einbauzustand ist die Dichtung zwischen einer dem ersten Gehäusebauteil zugeordneten ersten Grenzfläche und einer dem zweiten Gehäusebauteil zugeordneten zweiten Grenzfläche eingepresst. Dabei werden in dem Einbauzustand die metallischen Grenzflächen der beiden Gehäusebauteile über die metallischen Kontaktsegmente federnd elektrisch kontaktiert.

Der ein Elastomer aufweisende Dichtkörper kann dabei ausschließlich aus dem einen Elastomer gebildet sein. Alternativ ist es jedoch auch möglich, dass der Dichtkörper mehrere unterschiedliche Materialien, beispielsweise mehrere unterschiedliche Elastomere aufweist. Gegebenenfalls kann der Dichtkörper neben dem einen Elastomer auch einen weiteren, von einem Elastomer verschiedenen Kunststoff umfassen. Dass der Träger teilweise in den Dichtkörper eingebettet ist meint erfindungsgemäß, dass auch Bereiche des Trägers existieren, die nicht in den Dichtkörper eingebettet sind und beispielsweise aus diesem herausragen. Dies ist zum Beispiel für die Kontaktsegmente des Trägers der Fall. Dabei ist der Dichtkörper jedoch auf beiden Seiten, insbesondere auf einer Vorder- und einer Rückseite des metallischen Trägers vorhanden. Somit ist der Dichtkörper im Einbauzustand sowohl zwischen dem Träger und der ersten Grenzfläche, als auch zwischen dem Träger und der zweiten Grenzfläche angeordnet. Auf diese Weise gewährleistet die Dichtung im Einbauzustand eine hochwertige IP-dichtende Verbindung zwischen den beiden Gehäusebauteilen bzw. deren Grenzflächen. Andererseits werden über die federnden Kontaktsegmente die benachbarten metallischen Grenzflächen elektrisch miteinander verbunden, und bilden mitsamt dem Träger zwischen den Grenzflächen eine metallische Abschirmfläche, die nur Öffnungen einer derart kleinen Ausdehnung aufweist, dass ein Austreten elektromagnetischer Störsignale aus dem elektrischen oder elektronischen Gerät in die Umgebung wirksam reduziert wird. Dabei wird nicht nur das Austreten von elektromagnetischer Störstrahlung aus dem Inneren des Gerätes reduziert. Vielmehr wird auch eine Emission von elektromagnetischer Störstrahlung reduziert, die bei Geräten mit mehreren nicht ausreichend niederimpedant miteinander verbundenen Gehäusebauteilen aufgrund einer zeitlich fluktuierenden Spannungsdifferenz zwischen den Gehäusebauteilen verursacht wird. In diesem Fall wirken die verschiedenen Gehäusebauteile quasi als Antenne zur Aussendung der Störstrahlung. In der vorliegenden Erfindung erfolgt die elektrische Verbindung der benachbarten metallischen Grenzflächen - und damit der entsprechenden Gehäusebauteile - über eine Mehrzahl von Leitfähigkeitspfaden und in besonders niederimpedanter Art und Weise. Dies verhindert - zumindest jedoch reduziert - die Entstehung einer sich zeitlich ändernden Spannungsdifferenz zwischen den Gehäusebauteilen, wodurch die Emission auch dieser elektromagnetischen Störstrahlung wirksam reduziert wird. Die elektrischen Kontakte der Kontaktsegmente mit den Grenzflächen finden dabei nicht an dem Ort statt, der lokal die IP-dichtende Funktion über die Berührung des Dichtkörpers mit der betreffenden Grenzfläche bereitstellt. Vielmehr sind die elektrischen Kontakte ausreichend vom Kontakt der Grenzfläche mit dem Dichtkörper beabstandet und beeinträchtigen daher nicht die IP-dichtende Wirkung des Dichtkörpers zur Grenzfläche. Mit anderen Worten gibt es Bereiche der Grenzfläche, die in Verbindung mit dem Dichtkörper lediglich die IP-dichtende Wirkung bereitstellen. Auf diese Weise ist die erfindungsgemäße Dichtung in der Lage, einen hochwertigen IP-Schutz, insbesondere einen IP-Schutz der Klassen IP-4X, IP-5X und IP-6X bereitzustellen. Beabstandet von den Bereichen, die die IP-dichtende Wirkung bereitstellen, gibt es Bereiche, die von den elektrischen Kontaktsegmenten der erfindungsgemäßen Dichtung berührt werden und über die die beiden Grenzflächen elektrisch miteinander verbunden werden. Die Dichtung stellt auf diese Weise eine EMV-abschirmende Verbindung der beiden Grenzflächen bereit, die aufgrund der federnd ausgebildeten Kontaktsegmente auch lokal schwankende Abstände der zu kontaktierenden Grenzflächenbereiche zueinander - beispielsweise aufgrund von Maßtoleranzen, Temperaturwechsel und/oder Unebenheiten - ausgleicht. Durch die adhäsive und/oder formschlüssige Verbindung des Dichtkörpers mit dem Träger in Form eines Werkstoffverbundes kann die Dichtung auf einfache Art und Weise mit den Gehäusebauteilen des Geräts verbaut werden. Zusätzlich kann eine Herstellung des Trägers und des Dichtkörpers als Komponenten der Dichtung, wie auch deren Zusammenbau leicht automatisiert werden, wodurch insgesamt eine kostengünstige Dichtung resultiert.

Generell ist es möglich, dass die Dichtung durch eine offene Dichtung gebildet wird, deren Form geometrisch durch eine offene Kurve beschrieben wird. In einer vorteilhaften Ausführungsform ist jedoch die eine Dichtungsform beschreibende geometrische Kurve - und damit auch die Dichtung selbst - in sich geschlossen ausgebildet. In diesem Fall definiert die geschlossene Kurve den Umfang einer Dichtungsöffnung, wobei die Dichtungsöffnung prinzipiell eine beliebige Form aufweisen kann. Beispielsweise kann die Dichtungsöffnung - und damit die Dichtung - rund, oval oder vieleckig sein.

In einer Ausführungsform weist der Träger in dem von dem Dichtkörper eingebetteten Bereich einen flächigen Abschnitt auf. Dabei sind die den elektrischen Kontakt zu den metallischen Grenzflächen vermittelnden Kontaktsegmente gegenüber dem flächigen Abschnitt gewinkelt ausgebildet. Auf diese Weise wird in Verbindung mit einem geeigneten Werkstoff des metallischen Trägers eine Federung der Kontaktsegmente bewirkt, die im Einbauzustand der Dichtung Abstandsschwankungen der Grenzflächen zueinander ohne Qualitätseinbußen einer elektrischen Verbindung der Grenzflächen ausgleichen kann.

Abhängig von einem geplanten Einbauzustand der Dichtung können in einer Ausführungsform alle Kontaktsegmente an einem gleichen Randabschnitt an den flächigen Abschnitt des Trägers anschließen. Beispielsweise können sich bei einer runden geschlossenen Dichtung alle Kontaktsegmente entweder auf einem innenliegenden, oder aber auf einem außenliegenden Randabschnitt des Trägers - und somit der Dichtung - befinden. In einer hierzu alternativen Ausführungsform ist die Gesamtheit der Kontaktsegmente in eine erste Gruppe und eine zweite Gruppe an Kontaktsegmenten aufgeteilt. Dabei schließen die beiden Gruppen an gegenüberliegenden Randabschnitten des dem Träger zugeordneten flächigen Abschnitts an. Bezugnehmend auf den oben genannten Fall ist beispielsweise die erste Gruppe von Kontaktsegmenten an dem außenliegenden Randabschnitt angeordnet, während die zweite Gruppe von Kontaktsegmenten an dem innenliegenden Randabschnitt des dem Träger zugeordneten flächigen Abschnitts angeordnet ist. Im Hinblick auf die geschlossen ausgeführte Dichtung befinden sich damit Kontaktsegmente sowohl in einem inninliegenden, als auch in einem außenliegenden Bereich der Dichtung.

Abhängig von dem Anwendungsfall können die an den flächigen Abschnitt anschließenden Kontaktsegmente abwechselnd zueinander in unterschiedliche Richtungen gegenüber dem flächigen Abschnitt gewinkelt sein. So können beispielsweise die an einem bestimmten Randabschnitt des Trägers angeordneten Kontaktsegmente abwechselnd zueinander in unterschiedliche Richtungen abgewinkelt sein. Alternativ dazu ist es auch möglich, dass die an einem Randabschnitt des Abschnittes anschließenden Kontaktsegmente in eine Richtung abgewinkelt sind, während die an dem gegenüberliegenden Randabschnitt des flächigen Abschnitts anschließenden Kontaktsegmente in eine andere Richtung abgewinkelt sind.

In einer Ausführungsform der Dichtung umfasst der Dichtkörper zwei Teilkörper, die auf gegenüberliegenden Seiten des flächigen Abschnitts an dem Träger angeordnet sind. Beispielsweise ist ein erster Teilkörper auf einer Vorderseite, und ein zweiter Teilkörper auf einer Rückseite des Trägers angeordnet. Beide Teilkörper können separat ausgebildet und nicht miteinander verbunden sein. Alternativ dazu ist es jedoch auch möglich, dass der Dichtkörper einstückig ausgebildet ist und den flächigen Abschnitt sowohl auf der Vorderseite als auch auf der Rückseite des Trägers bedeckt oder gar umschließt. In beiden Ausführungsformen ist es möglich, dass der flächige Abschnitt Öffnungen aufweist, die von dem Dichtkörper bzw. von den Teilkörpern des Dichtkörpers durchsetzt werden. Über einen derartigen Formschluss wird ein mechanischer Verbund des Dichtkörpers mit dem Träger gestärkt und eine Relativbewegung zwischen Dichtkörper und Träger an deren Grenzfläche wirksam unterdrückt oder zumindest reduziert. Alternativ oder kumulativ dazu ist es auch möglich, dass der Dichtkörper adhäsiv, beispielsweise über einen Klebstoff mit dem Träger verbunden ist.

In einer vorteilhaften Ausführungsform ist der Träger als Stanzbiegeteil gebildet. Auf diese Weise lässt sich der Träger zusammen mit seinen abgewinkelten Kontaktsegmenten in großer Stückzahl und äußerst kostengünstig herstellen. Dabei sind die Kontaktsegmente integraler Bestandteil des metallischen Trägers. In einer Ausführungsform werden dabei die zwei Teilkörper des Dichtkörpers durch eine Anspritzung von dem Elastomer auf beide Seiten des Trägers - i. e. Vorder- und Rückseite - gebildet. In einer alternativen Ausführungsform, bei der der Dichtkörper einstückig ausgeführt ist, wird der Dichtkörper in Form einer Umspritzung des metallischen Trägers mit dem Elastomermaterial gebildet. In beiden Fällen wird jedoch nicht der gesamte Träger von dem Dichtkörper bedeckt. Vielmehr weisen die Kontaktsegmente des metallischen Trägers von dem Elastomer nicht bedeckte Bereiche auf, die letztendlich der elektrischen Kontaktierung mit den metallischen Bereichen an den Grenzflächen der Gehäusebauteile dienen. Auch das An- bzw. Umspritzen des Trägers mit dem Elastomer als Dichtkörper lässt sich in kurzer Zeit durchführen und leicht automatisieren, wodurch die Dichtung insgesamt kostengünstig hergestellt werden kann.

In einer Ausführungsform der Erfindung ist der Träger derart ausgeführt, dass Kontaktbereiche der Kontaktsegmente mit den Grenzflächen jeweils entlang eines geschlossenen EMV-Abschirmrings verlaufen, wobei entlang des EMV-Abschirmrings der Abstand zwischen benachbarten Kontaktbereichen konstant ist, insbesondere jedoch einen Abstands-Schwellwert nicht überschreitet. Dabei ist der Abstands-Schwellwert davon abhängig, bis zu welcher Grenzfrequenz die EMV-Abschirmung wirken soll, und sinkt mit steigender Grenzfrequenz. In einer besonders vorteilhaften Ausführung der Dichtung, wie sie z.B. für einen PWM-gesteuerten Wechselrichter als elektrisches Gerät eingesetzt wird, ist der Abstands-Schwellwert unter Berücksichtigung einer üblichen Taktfrequenz der zugeordneten Halbleiterschalter von ca. 50 kHz kleiner als 5 mm.

In einer Ausführungsform der Dichtung ist ein Material des Trägers aus der Gruppe Federstahl, Edelstahl, Kupfer, Aluminium, Messing, Bronze, Kupfer-Beryllium und einer Kombination hieraus ausgewählt. In einer weiteren Ausführungsform ist das Elastomer des Dichtkörpers aus der Gruppe Silikon-Kautschuk (VMQ), Acryl-Nitril-Butadien-Kautschuk (NBR), thermoplastisches Elastomer (TPE), Ethylen-Propylen-Dien-Kautschuk (EPDM), Poly-Urethan-Kautschuk (PUR) und einer Kombination hieraus ausgewählt.

Ein erfindungsgemäßes elektrisches oder elektronisches Gerät beinhaltet ein erstes Gehäusebauteil und ein mit dem ersten Gehäusebauteil verbundenes zweites Gehäusebauteil. Jedes der Gehäusebauteile umfasst jeweils eine Grenzfläche, wobei das erste Gehäusebauteil eine erste Grenzfläche und das zweite Gehäusebauteil eine zweite Grenzfläche aufweist. Dabei ist in einem zusammengebauten Zustand der Gehäusebauteile eine erfindungsgemäße Dichtung IP-dichtend und EMV-abschirmend zwischen den Grenzflächen der Gehäusebauteile angeordnet. Im Einbauzustand gewährleistet die Dichtung, dass das Gerät trotz der mehreren Gehäusebauteile einerseits eine gute EMV-Verträglichkeit aufweist und andererseits die betroffenen Gehäusebauteile des Gerätes IP-dichtend miteinander verbunden sind. Beide Funktionen werden an zwei benachbarten Grenzflächen lediglich mit einer zu verbauenden Komponente, nämlich der erfindungsgemäßen Dichtung als Werkstoffverbund realisiert. Es ergeben sich die bereits in Verbindung mit der Dichtung genannten Vorteile. Indem das Gerät mehrere Gehäusebauteile aufweist, kann darüber hinaus der Herstellprozess des Gerätes insgesamt effizienter und kostengünstiger gestaltet werden, da verschiedene Gehäusebauteile quasi parallel gefertigt werden können. Auch eine Montage der Gehäusebauteile gestaltet sich einfach, da die Dichtung als ein Verbundbauteil auf einfache Art und Weise montiert werden kann.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1a**: zeigt eine erfindungsgemäße Dichtung in einer ersten Ausführungsform; und
- **Fig. 1b**: zeigt den metallischen Träger der Dichtung aus Fig. 1a in einer Detailansicht; und
- **Fig. 2**: zeigt eine erfindungsgemäße Dichtung in einer zweiten Ausführungsform.
- **Fig. 3**: zeigt eine erfindungsgemäße Dichtung in einer dritten Ausführungsform.
- **Fig. 4a**: zeigt ein elektrisches oder elektronisches Gerät mit zwei Gehäusebauteilen, die unter Zwischenschaltung einer erfindungsgemäßen Dichtung miteinander verbunden sind; und
- **Fig. 4b**: zeigt einen Detailausschnitt des Gerätes aus Fig. 4a im Querschnitt bei dem die zwei Gehäusebauteile unter Zwischenschaltung einer erfindungsgemäßen Dichtung miteinander verbunden sind.

### FIGURENBESCHREIBUNG

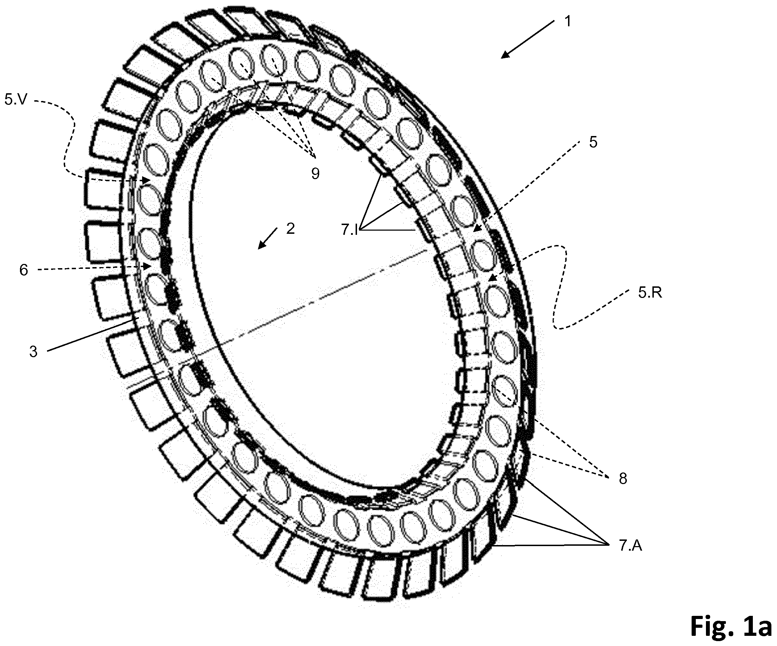

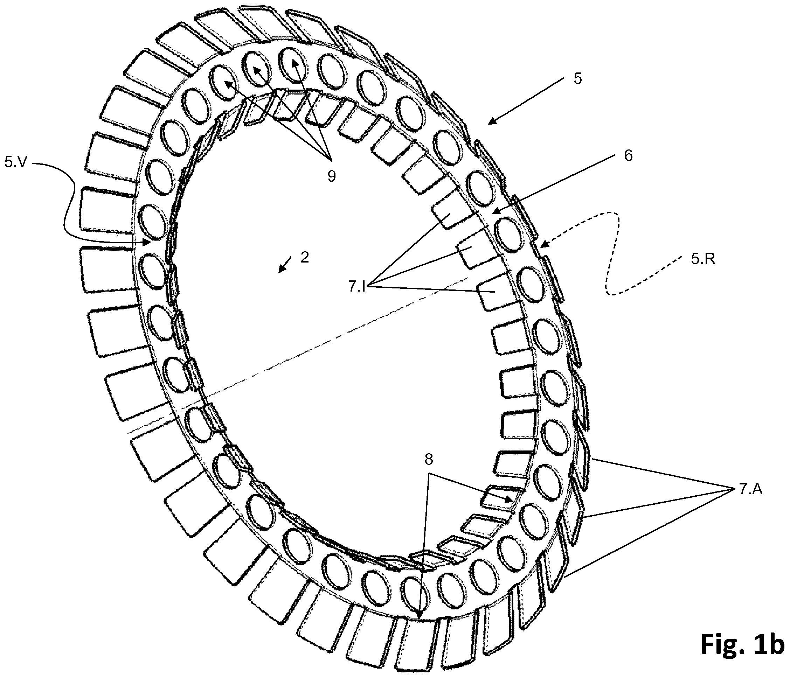

Die **Fig. 1** zeigt eine erste Ausführungsform einer erfindungsgemäßen Dichtung 1. Im dargestellten Fall handelt es sich um eine in sich geschlossene bzw. geschlossen umlaufende Dichtung 1 mit einer runden Dichtungsöffnung 2. Die Dichtung 1 beinhaltet einen Dichtkörper 3, in den ein metallischer Träger 5 eingebettet ist. Im dargestellten Fall ist der Dichtkörper 3 aus einem Elastomer einstückig und mit einem runden Querschnitt ausgeführt. Im Rahmen der Erfindung ist es jedoch auch möglich, dass der Dichtkörper 3 einen anderen, beispielsweise einen rechteckigen oder einen vieleckigen Querschnitt aufweist und/oder mehrstückig ausgeführt ist, das heißt mehrere nicht miteinander verbundene Teilkörper auf einer Vorerdseite 5.V und einer Rückseite 5.R des Trägers 5 umfasst. In Fig. 1a ist der Dichtkörper 3 teiltransparent dargestellt, weswegen auch Details des Trägers in dessen eingebettetem Bereich sichtbar sind. Der Übersichtlichkeit halber ist der metallische Träger 5 jedoch separat und in detaillierter Form nochmals in **Fig. 1b** dargestellt. Der metallische Träger 5 ist ebenfalls in sich geschlossen und weist einen flächigen Abschnitt 6 auf, an dessen Randabschnitten eine Vielzahl von abgewinkelten Kontaktsegmenten 7.A, 7.I angeschlossen sind. An den außenliegenden Randabschnitt des flächigen Abschnitts 6 schließt sich dabei eine erste Gruppe der Kontaktsegmente 7.A an, während eine zweite Gruppe der Kontaktsegmente 7.I an den innen liegenden Randabschnitt des flächigen Abschnitts 6 des Trägers 5 anschließt. Alle Kontaktsegmente 7.A, 7.I sind dabei durch eine Biegung entlang von in Umfangsrichtung ausgerichteten Biegelinien 8 in die gleiche Richtung, hier in Richtung einer Vorderseite 5.V des Trägers 5 abgewinkelt. Alternativ dazu ist es jedoch auch möglich, dass die Kontaktsegmente 7.A, 7.I in verschiedene Richtungen, beispielsweise die außen liegenden Kontaktsegmente 7.A in Richtung einer Vorderseite 5.V und die innen liegenden Kontaktsegmente 7.I in Richtung einer Rückseite 5.R des metallischen Trägers 5 abgewinkelt sind. Der flächige Abschnitt 6 des Trägers 5 weist eine Vielzahl von Öffnungen 9 auf, die von dem aus dem Elastomer gebildeten Dichtkörpers 3 durchsetzt werden. Der Träger 5 ist hier in Form eines Stanzbiegeteils ausgeführt, während der Dichtkörper 3 im dargestellten Fall durch ein Umspritzen des Trägers 5 mit dem Elastomer gebildet ist.

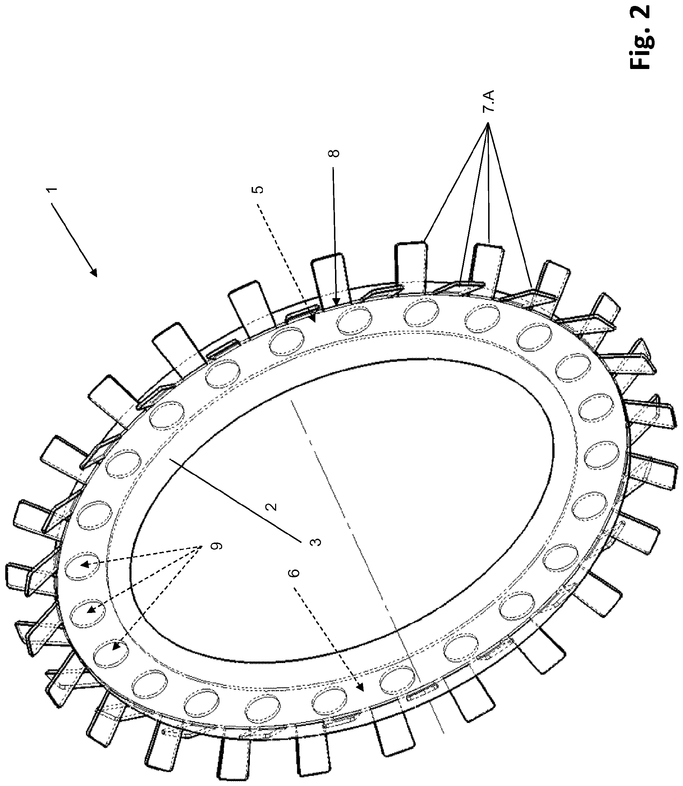

**Fig. 2** zeigt eine zweite Ausführungsform der erfindungsgemäßen Dichtung 1, die ähnlich zu der Dichtung 1 der in den Figuren 1a bzw. 1b dargestellten ersten Ausführungsform ausgebildet ist. Daher wird hier lediglich auf die Unterschiede der zweiten Ausführungsform eingegangen, während der restlichen Aspekte auf die Figurenbeschreibung der Figuren 1a und 1b verwiesen wird.

Im Unterschied zu den Figuren 1a und 1b weist der metallische Träger 5 der Dichtung 1 in der zweiten Ausführungsform lediglich eine Vielzahl von Kontaktsegmenten 7.A an dem außenliegenden Randabschnitt seines flächigen Abschnitts 6 auf, während an dem innenliegenden Randabschnitt kein Kontaktsegment anschließt. Die außenliegenden Kontaktsegmente 7.A sind dabei abwechselnd zueinander in unterschiedliche Richtungen abgewinkelt. Die Art und Weise, wie die Vielzahl der Kontaktsegmente 7.A relativ zu dem flächigen Abschnitt 6 abgewinkelt sind, hängt von dem jeweiligen Einbauzustand der Dichtung 1 in dem elektrischen bzw. elektronischen Gerät (hier nicht dargestellt) ab, und kann individuell gewählt werden. Alternativ zu einer Biegung entlang der in Umfangsrichtung gerichteten Biegelinie 8 ist auch eine Verdrehung der einzelnen Kontaktsegmente 7.A um eine durch das Zentrum der Dichtung 1 verlaufende Drehachse möglich. Auf diese Weise entsteht eine fächerartige Abwinkelung der Kontaktsegmente 7A. Entsprechendes gilt auch für die innenliegenden Kontaktsegmente 7.I aus den Figuren 1a bzw. 1b.

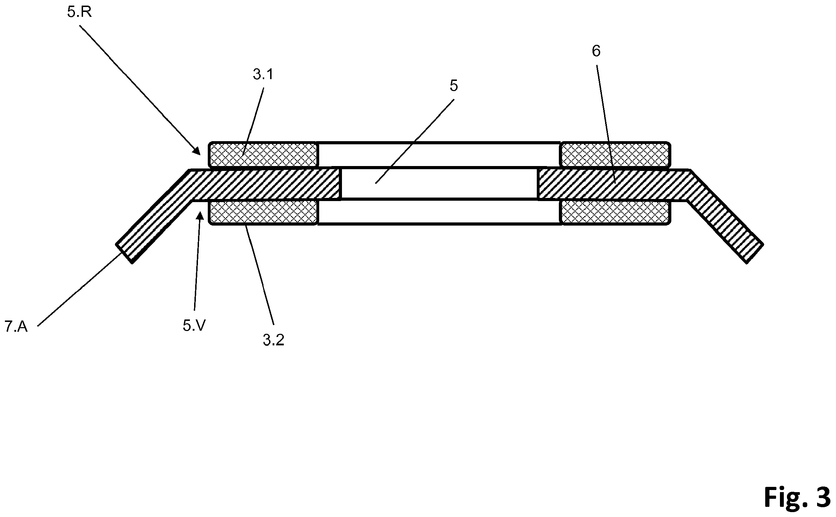

Die **Fig. 3** illustriert eine dritte Ausführungsform der erfindungsgemäßen Dichtung 1 in einer Querschnittsansicht. Auch hier ist die Dichtung 1 ähnlich zu den bereits beschriebenen Ausführungsformen aufgebaut, weswegen in Bezug auf gleichartig ausgeführte Merkmale auf die vorangegangenen Beschreibungen verwiesen wird Im Unterschied zu den vorigen Ausführungsformen ist der Dichtkörper 3 der hier dargestellten Dichtung 1 zweistückig ausgebildet. Ein erster Teilkörper 3.1 mit einem viereckigen Querschnitt ist an der Rückseite 5.R angeordnet, während ein zweiter Teilkörper 3.2 mit einem ebenfalls viereckigen Querschnitt an der Vorderseite 5.V des Trägers 5 angeordnet ist. Alternativ ist hier jedoch auch ein anderer, beliebig geformter Querschnitt der Teilkörper 3.1, 3.2 möglich, der beispielsweise dreieckig oder halbrund ausgeführt sein kann. Der flächige Abschnitt 6 des Trägers 5 weist in dieser Ausführungsform bevorzugt keine Öffnungen 9 auf. Beide Teilkörper 3.1, 3.2 des Dichtkörpers 3 sind hier separat ausgeführt und nicht miteinander verbunden. Jeder der Teilkörper 3.1, 3.2 ist dabei in Form einer Anspritzung oder Aufbringung von Elastomer an die jeweilige Seite 5.R, 5.V des Trägers 5 gebildet oder wird auf andere Weise adhäsiv mit dem Träger 5 verbunden. Obwohl die in den Figuren 1a, 1b, 2 und 3 dargestellten Ausführungsformen der Dichtung 1 eine runde und in sich geschlossene Form aufweisen, sind prinzipiell auch ovale, vieleckige und/oder offene Formen der Dichtung 1 möglich.

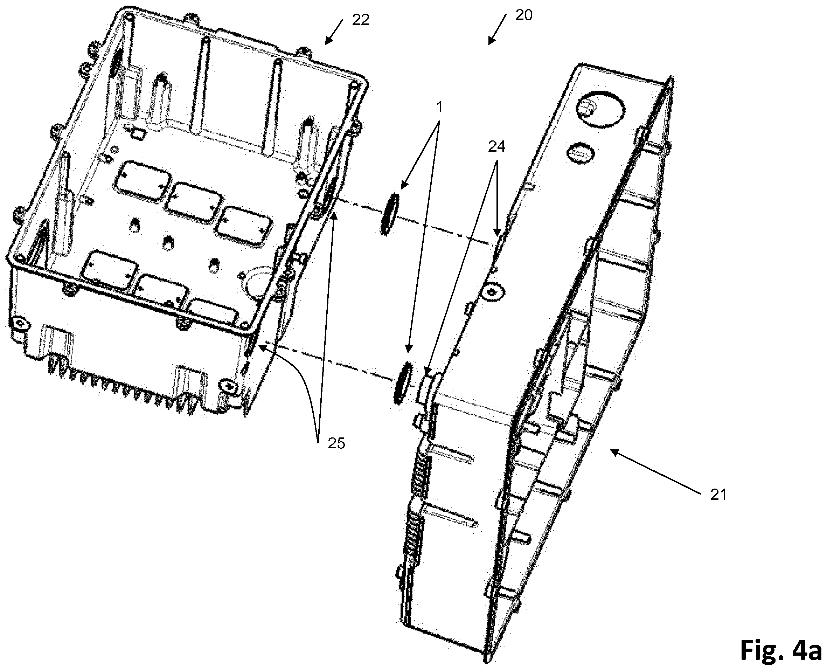

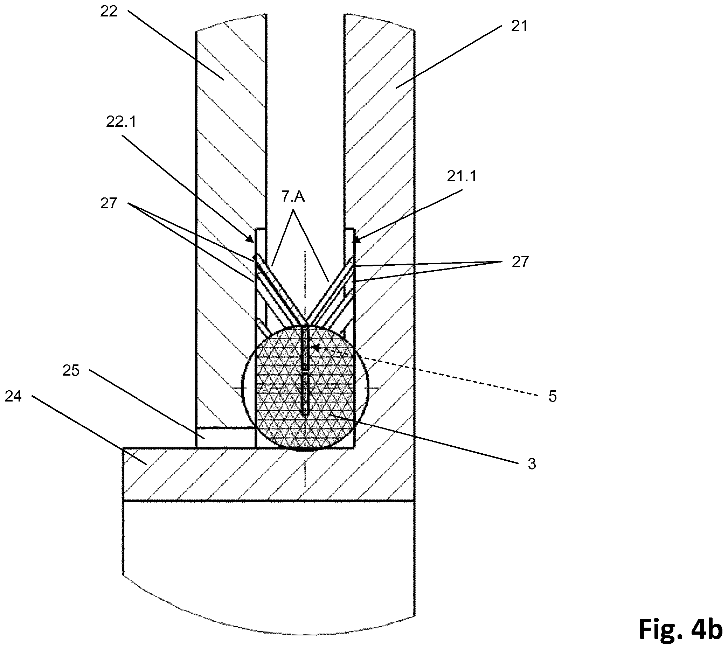

In **Fig. 4a** sind mehrere Gehäusebauteile 21, 22 eines elektrischen bzw. elektronischen Gerätes 20 in einer Explosions-Ansicht dargestellt. Bei einer Montage des Gerätes 20 wird ein erstes Gehäusebauteil 21 unter Zwischenschaltung einer oder mehrerer erfindungsgemäßer Dichtungen 1 mit einem zweiten Gehäusebauteil 22 verbunden. Dabei weist das erste Gehäusebauteil 21 einen rohrförmigen Fortsatz 24 auf, auf den die Dichtung 1 vor der Montage der Gehäusebauteile 21, 22 aufgeschoben und dadurch lateral fixiert wird. Beim Zusammenfügen beider Gehäusebauteile 21, 22 durchsetzt der rohrförmige Fortsatz 24 an dem ersten Gehäusebauteil 21 eine entsprechende Durchgangsbohrung 25 in dem zweiten Gehäusebauteil 22. Auf diese Weise wird im fertig montierten Zustand des Gerätes 20 ein Durchgang von dem ersten Gehäusebauteil 21 in das zweite Gehäusebauteil 22 gebildet. Der Durchgang kann beispielsweise als Kabeldurchführung zwischen beiden Gehäusebauteilen 21, 22 genutzt werden. Dabei sind beide Gehäusebauteile 21, 22 durch die erfindungsgemäße Dichtung 1 relativ zur Umgebung des Gerätes 20 abgedichtet. Gleichzeitig wird im Betrieb des Gerätes 20 eine Ausstrahlung elektromagnetischer Störsignale aus dem Geräte - Inneren in die Umgebung über die Kontaktsegmente 7.A, 7.I der erfindungsgemäßen Dichtung 1 wirksam reduziert. In Fig. 4b wird die Funktion der erfindungsgemäßen Dichtung 1 hinsichtlich ihrer EMV- abschirmenden Wirkung an Grenzflächen der beiden Gehäusebauteile 21, 22 nochmals detaillierter erläutert.

Die **Fig. 4b** zeigt eine Detailansicht der benachbarten Gehäusebauteile 21, 22 im montierten Zustand am Ort der Dichtung 1. Die Dichtung 1 ist auf den rohrförmigen Fortsatz 24 zwischen einer dem ersten Gehäusebauteil 21 zugeordneten ersten metallischen Grenzfläche 21.1 und einer dem zweiten Gehäusebauteil 22 zugeordneten zweiten metallischen Grenzfläche 22.1 angeordnet. Der rohrförmige Fortsatz 24 greift durch eine Bohrung 25 in dem zweiten Gehäusebauteil 22. Die Dichtung 1 wird im Einbauzustand über beide Grenzflächen 21.1, 22.2 verpresst. Auf diese Weise wird das Innere des Gerätes 20 gegenüber der Umgebung des Gerätes 20 abgedichtet. Im dargestellten Fall weist die Dichtung 1 lediglich Kontaktsegmente 7.A an dem außenliegenden Randabschnitt des dem Träger 5 zugeordneten flächigen Abschnitts 6 auf und entspricht damit der zweiten Ausführungsform gemäß Fig. 2. Hierbei kontaktieren die abwechselnd zueinander in verschiedenen Richtungen abgewinkelten Kontaktsegmente 7.A die metallischen Grenzflächen 21.1, 22.1 an verschiedenen Kontaktbereichen 27, wodurch die metallischen Grenzflächen 21.1, 22.1 der benachbarten Gehäusebauteile 21, 22 über eine Vielzahl verschiedener Leitfähigkeitspfade miteinander elektrisch verbunden werden. Über die Kontaktbereiche 27 der metallischen Grenzflächen 21.1, 22.1 mit den Kontaktsegmenten 7.A der Dichtung 1 wird so in Verbindung mit dem restlichen Träger 5 ein geschlossener EMV-Abschirmungsring gebildet. Über eine geeignete Wahl eines Abstandes zwischen benachbarten Kontaktsegmenten 7.A und damit der entsprechenden Kontaktbereiche 27 zueinander lässt sich die EMV-abschirmende Wirkung der Dichtung 1 individuell auf die abzuschirmenden elektromagnetischen Frequenzen abstimmen. Je höher eine abzuschirmende Frequenz ist, desto geringer ist der Abstand aufeinanderfolgender Kontaktsegmente 7.A zu wählen. Zusätzlich gilt ebenfalls, je höher eine Anzahl der Kontaktsegmente 7.A und damit der Leitfähigkeitspfade zwischen den Grenzflächen 21.1, 22.2, desto niederimpedanter ist die elektrische Verbindung der beiden der Gehäusebauteile 21, 22 miteinander. Gleichzeitig gleichen die rückfedernd ausgebildeten Kontaktsegmente 7.A lokale Schwankungen im Abstand der Grenzflächen zueinander, sowie lokale Unebenheiten der jeweiligen Grenzflächen 21.1, 22.2 ohne eine signifikante Verschlechterung der EMV-Abschirmung aus.

### BEZUGSZEICHENLISTE

- 1: Dichtung
- 2: Dichtungsöffnung
- 3: Dichtkörper
- 3.1: Teilkörper
- 3.2: Teilkörper

- 5: Träger
- 5.V: Vorderseite
- 5.R: Rückseite
- 6: Abschnitt

- 7.A: Kontaktsegment
- 7.I: Kontaktsegment
- 8: Biegelinie
- 9: Öffnung

- 20: Gerät
- 21: Gehäusebauteil
- 22: Gehäusebauteil
- 21.1: Grenzfläche
- 22.1: Grenzfläche
- 24: Fortsatz
- 25: Durchgangsbohrung
- 27: Kontaktbereich

## Patentansprüche

1. Dichtung (1) zur gemäß International Protection (IP) - Schutzart dichtenden und elektromagnetisch verträglich (EMV) abschirmenden Verbindung zwischen einem ersten (21) und einem zweiten Gehäusebauteil (22) eines elektrischen oder elektronischen Gerätes (20), umfassend
- einen ein Elastomer aufweisenden Dichtkörper (3) und
- einen in den Dichtkörper (3) teilweise eingebetteten metallischen Träger (5),
wobei
der Dichtkörper (3) und der Träger (5) adhäsiv und/oder formschlüssig miteinander verbunden sind und hierdurch einen Werkstoffverbund bilden, wobei der Träger (5) eine Mehrzahl aus dem Dichtkörper (3) herausragender Kontaktsegmente (7.I, 7.A) aufweist, die derart gestaltet sind, dass eine dem ersten Gehäusebauteil (21) zugeordnete erste Grenzfläche (21.1) und eine dem zweiten Gehäusebauteil (22) zugeordnete zweite Grenzfläche (22.2), zwischen denen die Dichtung (1) in einem Einbauzustand eingepresst ist, über die Kontaktsegmente (7.I. 7.A) federnd elektrisch kontaktiert werden.

2. Dichtung (1) nach Anspruch 1, wobei der Träger (5) im eingebetteten Bereich einen flächigen Abschnitt (6) aufweist, und wobei die Kontaktsegmente (7.I. 7.A) gegenüber dem flächigen Abschnitt (6) gewinkelt ausgebildet sind.

3. Dichtung (1) nach einem der vorherigen Ansprüche, wobei die Dichtung (3) in sich geschlossen ist, und insbesondere rund, oval oder vieleckig ist.

4. Dichtung (1) nach einem der Ansprüche 2 oder 3, wobei alle Kontaktsegmente (7.I., 7.A) an einem gleichen Randabschnitt an den flächigen Abschnitt (6) anschließen.

5. Dichtung (1) nach einem der Ansprüche 2 bis 3, wobei die Kontaktsegmente (7.I., 7.A) in eine erste Gruppe (7.I) und eine zweite Gruppe an Kontaktsegmenten (7.A) aufgeteilt sind, die an gegenüberliegenden Randabschnitten des flächigen Abschnitts (6) anschließen.

6. Dichtung (1) nach einem der Ansprüche 2 bis 5, wobei die an den flächigen Abschnitt (6) anschließenden Kontaktsegmente (7.I., 7.A) abwechselnd zueinander in unterschiedliche Richtungen gegenüber dem flächigen Abschnitt (6) gewinkelt sind.

7. Dichtung (1) nach einem der Ansprüche 2 bis 6, wobei der flächige Abschnitt (6) Öffnungen (9) aufweist, die von dem Dichtkörper (3) durchsetzt sind.

8. Dichtung (1) nach einem der Ansprüche 2 bis 7, wobei der Dichtkörper (3) einen einstückig gebildeten Dichtkörper umfasst, oder wobei der Dichtkörper (3) zwei Teilkörper (3.1, 3.2) beinhaltet, die auf gegenüberliegenden Seiten des flächigen Abschnitts (6) angeordnet sind.

9. Dichtung (1) nach einem der vorangehenden Ansprüche, wobei Kontaktbereiche (27) der Kontaktsegmente (7.I. 7.A) mit den Grenzflächen (21.1, 22.1) jeweils entlang eines geschlossenen EMV-Abschirmrings verlaufen, wobei entlang des EMV-Abschirmrings der Abstand zwischen benachbarten Kontaktbereichen kleiner als 5 mm ist.

10. Dichtung (1) nach einem der vorangehenden Ansprüche, wobei der Träger (5) als Stanzbiegeteil gebildet ist.

11. Dichtung (1) nach einem der vorangehenden Ansprüche, wobei der Dichtkörper (3) durch Anspritzung oder Umspritzung des Trägers (5) mit dem Elastomer gebildet ist.

12. Dichtung (1) nach einem der vorangehenden Ansprüche, wobei der Träger (5) ein Material aus der Gruppe Federstahl, Edelstahl, Kupfer, Aluminium, Messing, Bronze, Kupfer-Beryllium und eine Kombination hieraus aufweist.

13. Dichtung (1) nach einem der vorangehenden Ansprüche, wobei das Elastomer aus der Gruppe Silikon-Kautschuk (VMQ), Acryl-Nitril-Butadien-Kautschuk (NBR), thermoplastisches Elastomer (TPE), Ethylen-Propylen-Dien-Kautschuk (EPDM), Poly-Urethan-Kautschuk (PUR) und einer Kombination hieraus ausgewählt ist.

14. Elektrisches oder elektronisches Gerät (20) mit einem eine erste Grenzfläche (21.1) aufweisenden ersten Gehäusebauteil (21) und einem eine zweite Grenzfläche (22.1) aufweisenden zweiten Gehäusebauteil (22), wobei eine Dichtung (1) nach einem der vorangehenden Ansprüche IP-dichtend und EMV-abschirmend zwischen den Grenzflächen (21.1, 22.1) der Gehäusebauteile (21, 22) angeordnet ist.

## Claims

1. A seal (1) for a connection between a first housing component (21) and a second housing component (22) of an electrical or electronic device (20), said connection sealing in accordance with the International Protection (IP) degree of protection and shielding electromagnetically compatible (EMC), comprising
- an elastomer-comprising sealing body (3) and
- a metallic support (5) that is embedded to some extent in the sealing body (3),
**wherein**
the sealing body (3) and the support (5) are connected to one another in an adhesive and/or form-fitting manner and thus form a material bond, wherein the support (5) comprises a plurality of contact segments (7.1, 7.A), which project out of the sealing body (3) and are configured such that a first boundary surface (21.1) assigned to the first housing component (21) and a second boundary surface (22.2) assigned to the second housing component (22), between which the seal (1) is pressed in in an installed state, are electrically contacted in a resilient fashion via the contact segments (7.1, 7.A).

2. The seal (1) as claimed in claim 1, wherein, in the embedded region, the support (5) comprises a planar portion (6), and wherein the contact segments (7.1, 7.A) are designed at an angle in relation to the planar portion (6).

3. The seal (1) as claimed in either of the preceding claims, wherein the seal (3) is self-contained and is, in particular, round, oval or polygonal.

4. The seal (1) as claimed in either of claims 2 and 3, wherein all the contact segments (7.1, 7.A) adjoin the planar portion (6) along the same peripheral portion.

5. The seal (1) as claimed in either of claims 2 to 3, wherein the contact segments (7.1, 7.A) are divided up into a first group of contact segments (7.1) and a second group of contact segments (7.A) that adjoin opposite peripheral portions of the planar portion (6).

6. The seal (1) as claimed in one of claims 2 to 5, wherein the contact segments (7.1, 7.A) that adjoin the planar portion (6), are angled alternately to one another in different directions in relation to the planar portion (6).

7. The seal (1) as claimed in one of claims 2 to 6, wherein the planar portion (6) has openings (9), through which the sealing body (3) passes.

8. The seal (1) as claimed in one of claims 2 to 7, wherein the sealing body (3) comprises a single-piece sealing body, or wherein the sealing body (3) contains two sub-bodies (3.1, 3.2) that are arranged on opposite sides of the planar portion (6).

9. The seal (1) as claimed in one of the preceding claims, wherein regions of contact (27) of the contact segments (7.1, 7.A) with the boundary surfaces (21.1, 22.1) each run along a closed EMC shield ring, wherein, along the EMC shield ring, the distance between adjacent regions of contact is smaller than 5 mm.

10. The seal (1) as claimed in one of the preceding claims, wherein the support (5) is in the form of a punched and bent part.

11. The seal (1) as claimed in one of the preceding claims, wherein the sealing body (3) is formed by the elastomer being injection molded onto the support (5) or by the latter being encapsulated by the elastomer.

12. The seal (1) as claimed in one of the preceding claims, wherein the support (5) has a material from the group spring steel, stainless steel, copper, aluminum, brass, bronze, copper-beryllium and a combination thereof.

13. The seal (1) as claimed in one of the preceding claims, wherein the elastomer is selected from the group silicone rubber (VMQ), acrylonitrile butadiene rubber (NBR), thermoplastic elastomer (TPE), ethylene propylene diene monomer rubber (EPDM), polyurethane rubber (PUR) and a combination thereof.

14. An electrical or electronic device (20) having a first housing component (21) comprising a first boundary surface (21.1), and a second housing component (22) comprising a second boundary surface (22.1), wherein a seal (1) as claimed in one of the preceding claims is arranged with IP-sealing and EMC-shielding action between the boundary surfaces (21.1, 22.1) of the housing components (21, 22).

## Revendications

1. Joint (1) pour la connexion entre un premier (21) et un second composant de boîtier (22) d'un appareil électrique ou électronique (20), étanche selon la Protection Internationale (IP) et ayant une protection électromagnétique compatible (CEM), comprenant
- un corps d'étanchéité (3) comprenant un élastomère et
- un support métallique (5) partiellement noyé dans le corps d'étanchéité (3),
dans lequel
le corps d'étanchéité (3) et le support métallique (5) étant reliés l'un à l'autre par collage et/ou par complémentarité de forme et formant ainsi un matériau composite, le support métallique (5) comprenant une pluralité de segments de contact (7.I, 7.A) en saillie du corps d'étanchéité (3), qui sont conçus de telle sorte qu'une première interface (21.1) associée au premier composant de boîtier (21) et une deuxième interface (22.2) associée au deuxième composant de boîtier (22), entre lesquelles le joint (1) est enfoncé à l'état monté, sont en contact électrique élastique par l'intermédiaire des segments de contact (7.I, 7.A).

2. Joint (1) selon la revendication 1, dans lequel le support métallique (5) présente une partie plane (6) dans la zone d'encastrement, et dans lequel les segments de contact (7.I. 7.A) sont conçus pour être coudés par rapport à la partie plane (6).

3. Joint (1) selon l'une des revendications précédentes, dans lequel le joint (3) est fermé en lui-même, et en particulier est rond, ovale ou polygonal.

4. Joint (1) selon l'une des revendications 2 ou 3, dans lequel tous les segments de contact (7.I., 7.A) sont contigus à la partie plane (6) sur une même partie de bord.

5. Joint (1) selon l'une quelconque des revendications 2 à 3, dans lequel les segments de contact (7.I., 7.A) sont divisés en un premier groupe (7.I) et un second groupe de segments de contact (7.A) contigus à des parties de bord opposées de la partie plane (6).

6. Joint (1) selon l'une quelconque des revendications 2 à 5, dans lequel les segments de contact (7.I., 7.A) adjacents à la partie plane (6) sont alternativement inclinés les uns par rapport aux autres dans différentes directions par rapport à la partie plane (6).

7. Joint (1) selon l'une quelconque des revendications 2 à 6, dans lequel la partie plane (6) présente des ouvertures (9) à travers lesquelles passe le corps d'étanchéité (3).

8. Joint (1) selon l'une quelconque des revendications 2 à 7, dans lequel le corps d'étanchéité (3) comprend un corps d'étanchéité formé en une seule pièce, ou dans lequel le corps d'étanchéité (3) comprend deux corps partiels (3.1, 3.2) disposés sur des côtés opposés de la partie plane (6).

9. Joint (1) selon l'une des revendications précédentes, dans lequel les régions de contact (27) des segments de contact (7.I. 7.A) avec les interfaces (21.1, 22.1) s'étendent chacune le long d'un anneau de protection CEM fermé, dans lequel le long de l'anneau de protection CEM la distance entre des régions de contact adjacentes est inférieure à 5 mm.

10. Joint (1) selon l'une des revendications précédentes, dans lequel le support métallique (5) est formé comme une pièce pliée estampée.

11. Joint (1) selon l'une des revendications précédentes, dans lequel le corps d'étanchéité (3) est formé par le moulage ou le surmoulage du support métallique (5) avec l'élastomère.

12. Joint (1) selon l'une quelconque des revendications précédentes, dans lequel le support métallique (5) comprend un matériau choisi dans le groupe constitué par l'acier à ressort, l'acier inoxydable, le cuivre, l'aluminium, le laiton, le bronze, le cuivre-béryllium et une combinaison de ceux-ci.

13. Joint (1) selon l'une quelconque des revendications précédentes, dans lequel l'élastomère est choisi dans le groupe constitué par le caoutchouc de silicone (VMQ), le caoutchouc d'acrylonitrile-butadiène (NBR), l'élastomère thermoplastique (TPE), le caoutchouc d'éthylène-propylène-diène (EPDM), le caoutchouc de polyuréthane (PUR) et une combinaison de ceux-ci.

14. Appareil électrique ou électronique (20) avec un premier composant de boîtier (21) présentant une première interface (21.1) et un deuxième composant de boîtier (22) présentant une deuxième interface (22.1), un joint (1) selon l'une des revendications précédentes étant disposé de manière étanche à l'IP et protégée contre la CEM entre les interfaces (21.1, 22.1) des composants de boîtier (21, 22).
